# EUROPÄISCHE PATENTSCHRIFT

(11) **EP 1 277 245 B1**
(45) Veröffentlichungstag und Bekanntmachung des Hinweises auf die Patenterteilung: **13.09.2006**
(21) Anmeldenummer: 01925187.5
(22) Anmeldetag: 27.04.2001
(51) Int. Cl.: H01L 51/42

(54) **PHOTOVOLTAISCHE ZELLE**
PHOTOVOLTAIC CELL
CELLULE PHOTOVOLTAIQUE

(30) Priorität: 27.04.2000 AT 7352000
(43) Veröffentlichungstag der Anmeldung: 22.01.2003
(73) Patentinhaber: Konarka Austria Forschungs-und Entwicklungs GMBH, 4010 Linz (AT)
(72) Erfinder: SHAHEEN, Sean, Cave Creek, AZ 85331 (US); BRABEC, Christoph, A-4040 Linz (AT); FROMHERZ, Thomas, A-4112 Rottenegg (AT); PADINGER, Franz, A-4490 St. Florian (AT); SARICIFTCI, Sedar, A-4040 Linz (AT); GLOETZL, Erhard, A-4020 Linz (AT)
(74) Vertreter: Altenburg, Udo
(86) Internationale Anmeldenummer: PCT/AT2001/000128
(87) Internationale Veröffentlichungsnummer: WO 2001/084644

(56) Entgegenhaltungen:
- ROMAN L S ET AL: "MULTIFUNCTIONAL POLYTHIOPHENES IN PHOTODIODES" SYNTHETIC METALS, ELSEVIER SEQUOIA, LAUSANNE, CH, Bd. 102, Nr. 1-3, 12. Juli 1998 (1998-07-12), Seiten 977-978, XP001009591 ISSN: 0379-6779
- ROMAN L S ET AL: "HIGH QUANTUM EFFICIENCY POLYTHIOPHENE/C60 PHOTODIODES" ADVANCED MATERIALS, VCH VERLAGSGESELLSCHAFT, WEINHEIM, DE, Bd. 10, Nr. 10, 9. Juli 1998 (1998-07-09), Seiten 774-777, XP000774681 ISSN: 0935-9648
- GAO J ET AL: "POLYMER P-I-N JUNCTION PHOTOVOLTAIC CELLS" ADVANCED MATERIALS, VCH VERLAGSGESELLSCHAFT, WEINHEIM, DE, Bd. 10, Nr. 9, 18. Juni 1998 (1998-06-18), Seiten 692-695, XP000774675 ISSN: 0935-9648
- IIZUKA M ET AL: "OPTICAL AND ELECTRICAL PROPERTIES OF MULTI-LAYERED ORGANIC CELLS" MOLECULAR CRYSTALS AND LIQUID CRYSTALS, GORDON AND BREACH, LONDON, GB, Bd. 295, 28. Oktober 1997 (1997-10-28), Seiten 353-356, XP001009629 ISSN: 0026-8941
- APPERLOO J J ET AL: "Doping in solution as an order-inducing tool prior to film formation of regio-irregular polyalkylthiophenes" ADVANCED MATERIALS, 2 NOV. 2000, VCH VERLAGSGESELLSCHAFT, GERMANY, Bd. 12, Nr. 21, Seiten 1594-1597, XP001023165 ISSN: 0935-9648
- HO P K H ET AL: "ULTRATHIN SELF-ASSEMBLED LAYERS AT THE ITO INTERFACE TO CONTROL CHARGE INJECTION AND ELECTROLUMINESCENCE EFFICIENCY IN POLYMER LIGHT-EMITTING DIODES" ADVANCED MATERIALS, VCH VERLAGSGESELLSCHAFT, WEINHEIM, DE, Bd. 10, Nr. 10, 9. Juli 1998 (1998-07-09), Seiten 769-774, XP000774680 ISSN: 0935-9648

## Beschreibung

Die Erfindung bezieht sich auf eine Photovoltaische Zelle mit einer photoaktiven Schicht aus zwei molekularen Komponenten, nämlich einem Elektronendonator und einem Elektronenakzeptor, insbesondere einer konjugierten Polymerkomponente und einer Fullerenkomponente, und mit zwei beidseits der photoaktiven Schicht vorgesehenen, metallischen Elektroden.

Kunststoffe mit ausgedehnten π-Elektronensystemen, bei denen abwechselnd Einfach- und Doppelbindungen aufeinanderfolgen, werden als konjugierte Kunststoffe bezeichnet. Diese konjugierten Kunststoffe weisen hinsichtlich der Elektronenenergie mit Halbleitern vergleichbare Energiebänder auf, so daß sie auch durch ein Dotieren von nichtleitenden, in den metallisch leitenden Zustand überführt werden können. Beispiele für solche konjugierten Kunststoffe sind Polyphenylene, Polyvinylphenylene (PPV), Polythiophene oder Polyaniline. Der Wirkungsgrad der Energieumwandlung von photovoltaischen Polymerzellen aus einem konjugierten Polymer liegt allerdings typischerweise zwischen 10⁻³ und 10⁻² %. Zur Verbesserung dieses Wirkungsgrades wurden zwar bereits heterogene Schichten aus zwei konjugierten Polymerkomponenten vorgeschlagen (US 5 670 791 A), von denen eine Polymerkomponente als Elektronendonator und die andere Polymerkomponente als Elektronenakzeptor dienen. Durch den Einsatz von Fullerenen, insbesondere Buckminsterfullerenen C₆₀, als Elektronenakzeptoren (US 5 454 880 A) konnte die sonst übliche Ladungsträgerrekombination weitgehend vermieden werden, was zu einer erheblichen Wirkungsgradsteigerung führte. Für das Erreichen eines guten Wirkungsgrades ist eine gute Ladungstrennung eine notwendige, aber nicht hinreichende Bedingung, weil zusätzlich dafür gesorgt werden muß, daß die getrennten Ladungen auch zu den entsprechenden Elektroden der photovoltaischen Zelle gelangen. Bei üblichen photovoltaischen Zellen dieser Art haben sich eine lochsammelnde Elektrode aus Indium/Zinn-Oxid (ITO) und eine elektronensammelnde Elektrode aus Aluminium bewährt.

Der Erfindung liegt somit die Aufgabe zugrunde, eine photovoltaische Zelle der eingangs geschilderten Art so auszugestalten, daß der Ladungstransport zwischen der photoaktiven Schicht und den Elektroden im Sinne einer Steigerung des Kurzschlußstromes vergrößert werden kann.

Die Erfindung löst die gestellte Aufgabe dadurch, daß zwischen der photoaktiven Schicht und wenigstens einer Elektrode eine Zwischenschicht aus einem konjugierten Polymer vorgesehen ist, das eine dem Elektrodenpotential entsprechende Dotierung und hinsichtlich der Elektronenenergie eine Bandlükke zwischen dem Valenzband und dem Leitungsband von wenigstens 1,8 eV aufweist.

Da das konjugierte Polymer der Zwischenschicht im Sinne des Elektrodenpotentials dotiert ist, was im Bereich der lochsammelnden Elektrode eine oxidative und im Bereich der elektronensammelnden Elektrode eine reduktive Dotierung bedeutet, stellt das konjugierte Polymer im Bereich der lochsammelnden Elektrode einen Lochüberschuß, im Bereich der elektronensammelnden Elektrode jedoch einen Elektronenüberschuß sicher, so daß im Bereich des oxidativ dotierten Polymers die Lochleitung und im Bereich eines reduktiv dotierten Polymers die Elektronenleitung unterstützt wird. Da jedoch das konjugierte Polymer der jeweiligen Zwischenschicht hinsichtlich der Elektronenenergiebänder eine vergleichsweise große Bandlücke zwischen dem Valenzband und dem Leitungsband von zumindest 1,8 eV aufweist, ergibt sich eine entsprechend hohe Aktivierungsenergie für die Eigenleitung, was dazu führt, daß im Falle einer oxidativ dotierten Polymerschicht die Elektronenleitung von der photoaktiven Schicht zur lochsammeinden Elektrode und im Falle der reduktiv dotierten Zwischenschicht die Lochleitung von der photoaktiven Schicht zur elektronensammelnden Elektrode behindert werden. Mit Hilfe dieser besonderen Zwischenschichten kann somit eine Ventilwirkung erzielt werden, die die Leitung der an der jeweils anliegenden Elektrode zu sammelnden Ladungsträger von der photoaktiven Schicht zur Elektrode unterstützt, eine gleichgerichtete Diffusion gegenpoliger Ladung jedoch behindert. Als Ergebnis dieser besonderen Schichten kann die Ladungsleitung zu den Elektroden entsprechend verbessert werden, was sich unmittelbar in einer Vergrößerung des Kurzschlußstromes auswirkt. Es braucht wohl nicht besonders hervorgehoben zu werden, daß je nach Anwendungsfall photovoltaische Zellen mit einer solchen Zwischenschicht zwischen der lochsammelnden Elektrode und der photoaktiven Schicht, zwischen der elektronensammelnden Elektrode und der photoaktiven Schicht oder im Bereich beider Elektroden eingesetzt werden können.

Obwohl unterschiedliche konjugierte Polymere zur Ausbildung der Zwischenschichten entsprechend oxidativ oder reduktiv dotiert werden können, ergeben sich besonders vorteilhafte Verhältnisse, wenn die Zwischenschicht aus einem dotierten Polythiophen-Derivat besteht. Unter dem Begriff Polymer sind dabei Hochpolymere als auch Oligomere zu verstehen.

In der Zeichnung ist der Erfindungsgegenstand beispielsweise dargestellt. Es zeigen
Fig. 1 eine erfindungsgemäße photovoltaische Zelle ausschnittsweise in einem schematischen Schnitt und
Fig. 2 die Strom-Spannungskennlinie einer herkömmlichen und einer erfindungsgemäßen photovoltaischen Zelle.

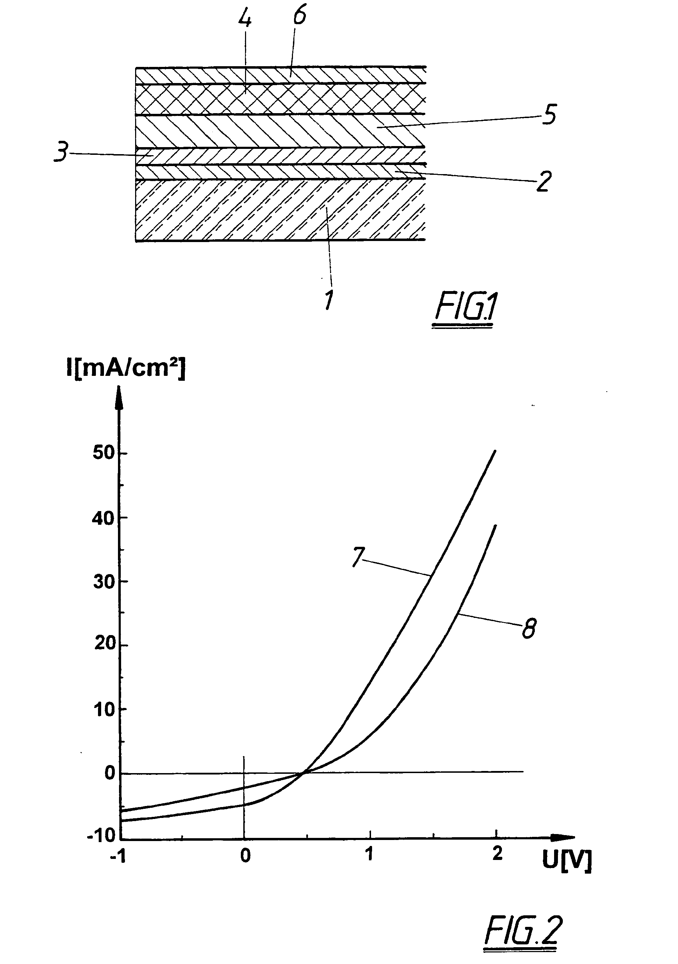

Die photovoltaische Zelle gemäß der Fig. 1 weist einen lichtdurchlässigen Glasträger 1 auf, auf dem eine Elektrodenschicht 2 aus einem Indium/Zinn-Oxid (ITO) aufgebracht ist. Diese Elektrodenschicht 2 bildet im allgemeinen eine vergleichsweise rauhe Oberflächenstruktur, so daß sie mit einer Glättungsschicht 3 aus einem durch eine entsprechende Dotierung elektrisch leitfähigen Polymer, üblicherweise PEDOT, abgedeckt wird. Im Gegensatz zu herkömmlichen photovoltaischen Zellen dieser Art wird nach der Erfindung die photoaktive Schicht 4 nicht unmittelbar auf die Glättungsschicht aufgebracht, sondern auf eine Zwischenschicht 5, die aus einem konjugierten Polymer, vorzugsweise aus einem Poly3-Alkylthiophen, besteht, das nach dem Aufbringen auf die Glättungsschicht 3 mit Nitrosonium-Tetrafluorroborat oxidativ dotiert wurde, um einen entsprechenden Lochüberschuß zu erhalten.

Die photoaktive Schicht 4, die auf die Zwischenschicht 5 in Form einer Lösung aufgebracht wird, besteht aus einem konjugierten Polymer, vorzugsweise einem Polythiophen-Derivat, als Elektronendonator und einem Fulleren, insbesondere funktionalisiertes Fulleren PCBM, als Elektronenakzeptor. Unter dem Begriff Polymer sind dabei sowohl Hochpolymere als auch Oligomere zu verstehen. Die elektronensammelnde Elektrode 6 besteht aus Aluminium, das im Falle des dargestellten Ausführungsbeispieles auf die photoaktive Schicht 4 ohne Zwischenschaltung einer weiteren Zwischenschicht aufgedampft wird, was jedoch durchaus möglich wäre. In diesem Fall wäre das konjugierte Polymer der Zwischenschicht entsprechend dem negativen Potential der elektronensammelnden Elektrode 6 reduktiv zu dotieren, um einen entsprechenden Elektronenüberschuß sicherzustellen.

Aufgrund der Zwischenschicht 5, die zwischen dem Valenzband und dem Leitungsband eine Bandlücke von wenigstens 1,8 eV aufweist, wird wegen dieser vergleichsweise breiten Bandlücke der Eintritt von Elektronen aus der photoaktiven Schicht 4 in die Zwischenschicht 5 erschwert, ohne die Lochleitung zwischen der photoaktiven Schicht 4 und der lochsammeinden Elektrode 2 zu beeinträchtigen. Das Leitungsband des konjugierten Polymers der Zwischenschicht 5 liegt z. B. im Gegensatz zu der PEDOT-Schicht 3 auf einem deutlich höheren Energieniveau als das Energieband des Elektronenakzeptors der photoaktiven Schicht 4. Dies bedeutet einen unipolaren Ladungsübergang von der photoaktiven Schicht 4 zur lochsammelnden Elektrode 2, was sich in einer entsprechenden Vergrößerung des Kurzschlußstromes bemerkbar macht, wie dies der Fig. 2 entnommen werden kann. In dieser Fig. 2 ist die Stromdichte I über der Spannung U bei einer Anregungsenergie von 80 mW/cm² unter simulierten AM 1,5 Bedingungen für eine erfindungsgemäße photovoltaische Zelle im Vergleich zu einer mit Ausnahme der Zwischenschicht 5 übereinstimmend aufgebauten Zelle aufgetragen. Es zeigt sich, daß die der erfindungsgemäßen photovoltaischen Zelle zugehörige Kennlinie 7 einen bei der Spannung U = 0V gemessenen Kurzschlußstrom ergibt, der etwa doppelt so groß wie der Kurzschlußstrom der Vergleichszelle gemäß der Kennlinie 8 ist.

Es braucht wohl nicht näher ausgeführt zu werden, daß bei einer Anordnung der Zwischenschicht 5 zwischen der photoaktiven Schicht 4 und der elektronensammelnden Elektrode 6 der Abstand der Valenzbänder und nicht der Leitungsbänder ausschlaggebend ist.

Da die Wirkung der elektrisch isolierenden Übergangsschicht 6 nicht auf konjugierte Polymere als Elektronendonator und Fullerene als Elektronenakzeptor beschränkt ist, kann die erfindungsgemäße Wirkung auch bei allen photovoltaischen Zellen mit einer molekularen Zweikomponentenschicht aus einem Elektronendonator und einem Elektronenakzeptor beobachtet werden.

## Patentansprüche

1. Photovoltaische Zelle mit einer photoaktiven Schicht (4) aus zwei molekularen Komponenten, nämlich einem Elektronendonator und einem Elektronenakzeptor, und mit zwei beidseits der photoaktiven Schicht (4) vorgesehenen, metallischen Elektroden (2, 6), **dadurch gekennzeichnet, daß** zwischen der photoaktiven Schicht (4) und wenigstens einer Elektrode (2, 6) eine Zwischenschicht (5) aus einem konjugierten Polymer vorgesehen ist, das eine dem Elektrodenpotential entsprechende Dotierung und hinsichtlich der Elektronenenergiebänder eine Bandlücke zwischen dem Valenzband und dem Leitungsband von wenigstens 1,8 eV aufweist.

2. Photovoltaische Zelle nach Anspruch 1, **dadurch gekennzeichnet, daß** die Zwischenschicht (5) aus einem dotierten Polythiophen-Derivat besteht.

3. Photovoltaische Zelle nach Anspruch 1 oder 2, **dadurch gekennzeichnet, daß** die zwei molekularen Komponenten der photoaktiven Schicht eine konjugierte Polymerkomponente und eine Fullerenkomponente sind.

## Claims

1. A photovoltaic cell having a photoactive layer (4) composed of two molecular components, in particular an electron donor and an electron acceptor, and having two metal electrodes (2, 6) provided on either side of the photoactive layer (4), **characterised in that** between the photoactive layer (4) and at least one electrode (2, 6), an intermediate layer (5) is provided, being composed of a conjugated polymer, which has doping corresponding to the electrode potential and, in terms of the electron energy bands, has a band gap between the valency band and the conduction band of at least 1.8 eV.

2. A photovoltaic cell according to claim 1, **characterised in that** the intermediate layer (5) consists of a doped polythiophene derivative.

3. A photovoltaic cell according to claim 1 or 2, **characterised in that** the two molecular components of the photoactive layer are a conjugated polymer component and a fullerene component.

## Revendications

1. Une cellule photovoltaïque comprenant une couche photoactive (4) constituée de deux composants moléculaires, à savoir un donneur d'électrons et un accepteur d'électrons, et comprenant deux électrodes métalliques (2, 6) prévues des deux côtés de la couche photoactive (4), **caractérisée en ce qu'**il est prévu, entre la couche photoactive (4) et au moins une électrode (2, 6), une couche intermédiaire (5) constituée d'un polymère conjugué, qui dispose d'un dopage correspondant au potentiel de l'électrode et, vis-à-vis des bandes d'énergie des électrons, d'une bande interdite entre la bande de valence et la bande de conduction d'au moins 1,8 eV.

2. Une cellule photovoltaïque selon la revendication 1, **caractérisée en ce que** la couche intermédiaire (5) est constituée d'un dérivé de polythiophène dopé.

3. Cellule photovoltaïque selon la revendication 1 ou 2, **caractérisée en ce que** les deux composants moléculaires de la couche photoactive sont un composant en polymère conjugué et un composant en fullerène.
